# FASCICULE DE BREVET EUROPEEN

(11) **EP 0 716 448 B1**
(45) Date de publication et mention de la délivrance du brevet: **31.03.1999**
(21) Numéro de dépôt: 95460042.5
(22) Date de dépôt: 08.12.1995
(51) Int. Cl.: H01L 23/544

(54) **Procédé de marquage de circuits intégrés avec un laser**
Verfahren zur Kennzeichnung von integrierten Schaltungen mit einem Laser
Method for marking integrated circuits with a laser

(30) Priorité: 09.12.1994 FR 9415151
(43) Date de publication de la demande: 12.06.1996
(73) Titulaire: STMicroelectronics S.A., 94250 Gentilly (FR)
(72) Inventeur: Cadet, Bernard, F-56100 Lorient Cédex (FR)
(74) Mandataire: Schmit, Christian Norbert Marie

(56) Documents cités:
- EP-A- 0 134 469
- GB-A- 2 262 839
- US-A- 4 945 204
- PATENT ABSTRACTS OF JAPAN vol. 16 no. 224 (E-1206) ,25 Mai 1992 & JP-A-04 039947 (MITSUBISHI) 10 Février 1992,

## Description

L'invention concerne un procédé de marquage de circuits intégrés avec un laser. Un tel procédé permet de marquer physiquement des circuits jugés défectueux lors d'une étape de test, afin de pouvoir repérer de manière optique ces circuits, et les écarter d'étapes ultérieures d'encapsulation.

La fabrication de circuits intégrés comprend plusieurs étapes.

Tout d'abord, on procède à la réalisation physique des circuits intégrés proprement dits à partir d'une tranche de silicium, en employant des procédés de dopage, de métallisation, et de déposition d'une couche de passivation (faite de nitrure, d'oxyde, ou d'oxyde de polysilicium), bien connus de l'homme du métier.

Typiquement, une tranche de silicium a un diamètre de quelques dizaines de centimètres. Sur une tranche, on réalise un nombre plus ou moins important de circuits identiques, suivant la surface relative de ces circuits par rapport à la surface de la tranche.

Puis, on teste généralement ces circuits à l'aide d'un appareil de test sous pointes (wafer prober en littérature anglo-saxonne). Le principe est d'amener des pointes métalliques au contact du circuit (typiquement au niveau de plots de soudure de fils du circuit). En forçant et/ou en mesurant des signaux électriques relatifs à des caractéristiques fonctionnelles prévues du circuit, on peut comparer le fonctionnement du circuit par rapport à un fonctionnement jugé satisfaisant pour l'ensemble de ces caractéristiques. Par exemple, on testera la tension produite par une alimentation interne, la consommation, la réaction du circuit par rapport à des signaux de commande (si par exemple le circuit doit exécuter un programme mémorisé dans le circuit), un temps de réaction etc.

Une fois les tests effectués, on procède à la découpe de la tranche de silicium pour individualiser les circuits, et on procède à leur encapsulation, c'est à dire à leur mise sous boîtier.

Si, le test d'au moins une caractéristique révèle un comportement d'un circuit qui n'est pas acceptable par rapport à ce que le fabricant garantit, on doit écarter après la phase de découpe ce circuit de la chaîne de fabrication pour qu'il ne soit pas ultérieurement encapsulé et utilisé dans une application.

Pour se faire on le marque physiquement, c'est à dire qu'on modifie son aspect extérieur, afin qu'il soit reconnu ultérieurement comme défectueux. La reconnaissance s'effectue de manière optique par un appareil.

Classiquement, le marquage s'effectue en déposant, par projection pneumatique ou par capillarité, une goutte d'encre à la surface du circuit, sur la couche de passivation superficielle.

Ce marquage peut être effectué au fur et à mesure que les circuits d'une tranche sont testés, l'extrémité du dispositif d'encrage (appelé tête d'encrage) étant positionné entre les pointes de test. Il peut aussi être réalisé une fois que tous les circuits on été testés, soit par le même appareil, soit sur un autre appareil (encrage dit différé). Les dimensions des circuits tendant de plus en plus à se réduire, on se dirige de plus en plus vers l'utilisation d'un encrage différé. On utilise alors un ou des appareils exclusivement dédiés au test des tranches, et un ou d'autres appareils exclusivement dédiés au marquage des circuits jugés défectueux des tranches testées. On choisit classiquement d'utiliser une encre de couleur opaque (noire par exemple), la tranche étant de couleur argentée ou jaunâtre.

Ce procédé présente un certain nombre d'inconvénients :
- production de taches non reproductibles à l'identique. On observe une certaine dispersion quant aux caractéristiques des taches. Le diamètre et la forme des taches varient en fonction des sollicitations de l'encrier (le nombre de taches à effectuer est variable suivant les tranches de silicium). Or, les équipements automatiques qui sélectionnent les circuits pour les écarter après découpe se repèrent sur la morphologie de la tache, c'est à dire son diamètre et sa forme (et non pas seulement sur la présence d'encre). Typiquement, pour marquer des circuits ayant une surface de l'ordre du millimètre carré, pour un diamètre de tache souhaité de 600 µm, on observe habituellement des variations de l'ordre de plus ou moins 200 µm. Si les taches sont trop petites ou mal formées, il est nécessaire de déposer à nouveau une goutte d'encre à l'aide d'un encrier manuel actionné par un opérateur. Cela peut ralentir de manière sensible la productivité d'une chaîne de fabrication.
- présence de bavures. Il arrive que la tache s'étale au delà de la surface occupée par le circuit, et que de l'encre vienne en contact avec des circuits voisins ou avec des pointes de test (si le test et l'encrage sont réalisés par un seul appareil), ce qui peut nécessiter des interventions humaines ou perturber le déroulement du test en introduisant des signaux parasites. La présence de bavures peut ainsi induire le marquage de circuits qui ne seraient pas jugés défectueux si il n'y avait pas de bavure.
- dépôt d'encre sur la plate-forme supportant la tranche lors des tests, particulièrement lors de marquage de circuits situés sur la périphérie de la tranche de silicium. Or, cette plate-forme est une plate-forme métallique assurant la continuité électrique sur la face arrière de la tranche, et qui forme un plan de masse. Il est alors nécessaire qu'un opérateur enlève cette encre avant la mise en place de la tranche suivante sur la plate-forme. Cela induit des pertes de temps supplémentaires.

Le but de l'invention est de remédier à ces inconvénients.

GB-A-2262 839 concerne un procédé de marquage au laser sur tranche de silicium consistant à inscrire par rayon laser, dans des zones inactives de la tranche testée, des informations binaires concernant l'ensemble de circuits intégrés de la tranche.

L'invention propose un procédé de marquage physique sur tranche de silicium selon les revendications.

L'invention propose donc de faire varier l'aspect de la surface des circuits défectueux par échauffement de cette surface, en lieu et place du dépôt d'une couche d'encre.

Contrairement au marquage à l'encre, le marquage au laser permet d'obtenir une très grande directivité du marquage, de par la cohérence spatiale du rayonnement laser.

On pourra donc :
- diminuer fortement les variations de diamètre de marquage et descendre, par exemple, de plus ou moins 200 microns (encre) à plus ou moins 10 microns.
- éliminer le risque de bavure et de marquage de la plate-forme supportant la tranche.

Cette cohérence permet par ailleurs d'obtenir une importante concentration d'énergie par unité de surface.

Les circuits étant recouverts d'au moins une couche de passivation, on fait fondre les couches superficielles des circuits jugés défectueux sur une profondeur supérieure à l'épaisseur de cette couche de passivation.

Le marquage à l'encre ne modifie pas la structure des circuits jugés défectueux. L'encre forme une couche qui est simplement déposée et qui se superpose donc aux autres couches du circuit. Du fait du risque de bavure, on choisit en effet une encre qui ne modifie pas chimiquement le circuit. Entre autres choses, on veille à ce que l'encre ne contienne pas de sodium.

Lors du marquage au laser, le changement d'aspect de la surface d'un circuit s'obtient par échauffement et fusion d'une ou plusieurs couches superficielles du circuit. La surface du circuit prendra alors typiquement une couleur brunâtre, repérable de manière optique.

Grâce à la grande cohérence spatiale du rayonnement laser, le marquage pourra être destructif, c'est à dire qu'on pourra modifier le circuit de manière à le rendre inopérant. Il suffit pour cela d'utiliser une puissance laser et un temps d'exposition de la surface du circuit suffisants pour obtenir une fusion d'une ou plusieurs couches actives, situées sous la couche de passivation (d'une épaisseur typique de l'ordre de 1 à 2 microns). Par couche active, on entend une couche intervenant dans le fonctionnement électrique d'un circuit. Une couche de passivation est une couche de protection mécanique, et est indépendante de la fonction d'un circuit.

Le marquage laser permet d'obtenir une surface de marquage très réduite, de par la très grande directivité du rayonnement laser. C'est pourquoi, dans une version en variante, on marque la puce défectueuse en plusieurs endroits, par exemple suivant une figure géométrique.

Le marquage à l'encre n'étant pas destructif, il se peut qu'un circuit jugé défectueux soit apte à fonctionner normalement. En effet, les tests des circuits ne portent pas seulement sur la capacité du circuit à fonctionner ou non, mais également sur le respect de capacités de fonctionnement relatives. Ainsi, par exemple, on cherche à garantir une certaine durée de vie du circuit en fonctionnement, un niveau maximal de consommation etc. Un circuit pourra donc être apte à remplir une fonction donnée mais être par ailleurs jugé défectueux. Dans ce cas, si ce circuit n'est malencontreusement pas reconnu comme tel, et est donc soumis à une encapsulation, il pourra être utilisé, ses défauts ne se manifestant que tardivement. On ne peut pas non plus écarter le risque d'utilisation frauduleuse de ces circuits si ils ne sont pas détruits.

Le caractère éventuellement destructif du marquage trouve un intérêt tout particulier dans le cadre de la fabrication de circuits destinés à des applications sensibles, que ce soit au niveau :
- de l'utilisation (applications bancaires par exemple, en ce qui concerne entre autres le risque de fraude),
- de l'assurance d'une garantie donnée (applications dans des systèmes de sécurité, au sens large, des biens et/ou des personnes, ou dans des systèmes inaccessibles, tels que les satellites par exemple).

L'invention ne se contente donc pas de résoudre des problèmes techniques relatifs à l'utilisation d'encre, mais procure une nouvelle caractéristique particulièrement importante.

D'autres particularités apparaîtront à la lecture de la description détaillée qui suit d'un exemple de réalisation d'une machine de test mettant en oeuvre l'invention, et qui est faite en référence aux dessins annexés dans lesquels :
- la figure 1 représente schématiquement un appareil de marquage permettant de mettre en oeuvre l'invention,
- la figure 2 représente un laser de l'appareil de marquage.

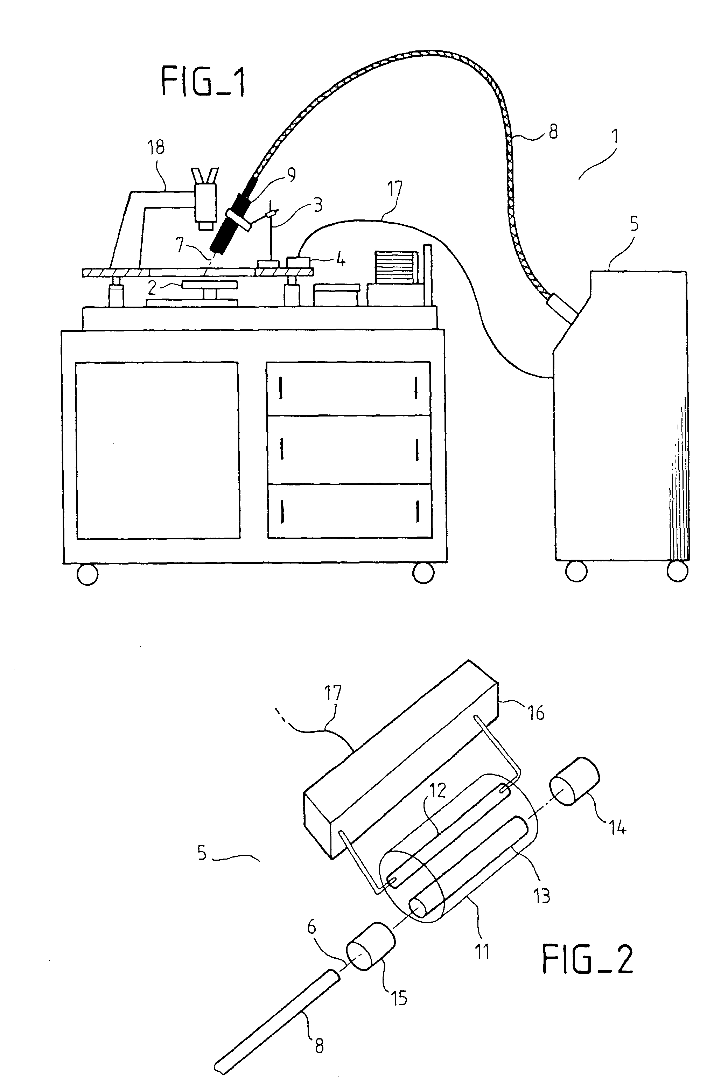

La figure 1 représente un appareil de marquage 1.

Cet appareil 1 comprend :
- un plate-forme 2 horizontale pour recevoir des tranches de silicium après réalisation sur ces tranches de circuits intégrés,
- des moyens mécaniques, représentés sous la forme d'une potence 3 pour positionner à proximité de la plate-forme 2 une extrémité d'un dispositif de marquage,
- un circuit de commande 4.

Le dispositif de marquage comprend :
- un laser 5 afin de produire un faisceau laser 6, et
- une interface optique pour amener au moins une fraction du faisceau laser produit au contact de la surface des circuits intégrés.

L'interface optique comprend :
- un support de transmission, ici une fibre optique 8, comprenant une entrée et une sortie, l'entrée étant placée en sortie du laser 5 de manière à ce que le faisceau laser 6 produit par le laser 5 soit canalisé dans le support de transmission,
- un dispositif de collimation, placés entre la sortie de la fibre optique 8 et la plate-forme 2, pour produire un faisceau laser dérivé 7 à partir du faisceau laser 6.

Classiquement, le dispositif de collimation 9 aura une position fixe lors du marquage des circuits d'une tranche, et on déplacera la plate-forme 2 transversalement pour amener les circuits intégrés jugés défectueux au contact du faisceau laser 7.

Pour réaliser cet appareil 1, on pourra adapter un appareil de marquage traditionnel, telle par exemple que l'appareil LSW 4000 fabriqué par la société Baasel. En effet, hormis le fait que le "produit" de marquage est différent, les dispositifs mécaniques connexes (plate-forme, potence, moyens de translation de la plate-forme, etc.) et leurs moyens de commande ne différeront pas de ceux d'un appareil de marquage traditionnel, la fonction recherchée étant identique.

Bien qu'on puisse envisager de mettre au point un appareil réalisant à la fois les tests et le marquage des circuits à tester, on prendra en pratique un appareil spécifiquement dédié au marquage pour les raisons suivantes :
- si on souhaite pouvoir marquer de circuits d'une surface très réduite, de l'ordre du millimètre carré par exemple, il sera difficile, voire impossible, de positionner l'extrémité du dispositif de marquage entre ou à coté des pointes de tests,
- la mise au point d'appareils distincts pour la marquage et le test permet de s'affranchir de problèmes d'interférences et de gestion de fonctionnement entre les deux fonctions,
- si un appareil est sujet à un dysfonctionnement et doit être arrêté pour réparation, une seule opération, de test ou de marquage, sera suspendue,
- la durée du marquage d'un circuit étant généralement beaucoup plus rapide (quelques millisecondes) que la durée des tests (pouvant atteindre quelques dizaines de secondes), on pourra d'une part utiliser un seul appareil de marquage pour plusieurs appareils de test, et d'autre part utiliser des appareils de test déjà existant, sans avoir à les changer ou les modifier pour recevoir le laser.

Selon un mode de réalisation en variante, la plate-forme sur laquelle repose la tranche de silicium, est fixe. Pour effectuer le marquage des puces défectueuses, on déplace l'interface optique.

La figure 2 illustre un exemple de réalisation du laser 5 de la figure 1.

On utilisera par exemple un laser à solide de type YAG (Yttrium Aluminium Garnet). Le YAG est un matériau cristallin. C'est un grenat d'yttrium et d'aluminium dopé au néodyme. Sa longueur d'onde est donc de 1060 nanomètres, comme pour le verre au néodyme.

Les avantages principaux du YAG résident dans un seuil bas, autorisant le pompage optique par une source à émission continue, un bon rendement, et une conductivité thermique nettement supérieure à celle du verre. Ces qualités permettent, dans le fonctionnement impulsionnel, une cadence d'émission bien supérieure à celle des autres matériaux solides (rubis, verre au néodyme). En effet, l'échauffement du barreau laser conduit à des gradients de température qui modifient ses qualités géométriques et optiques, et peuvent aller jusqu'à interdire toute oscillation. L'amélioration du rendement et du refroidissement représentent donc un facteur essentiel pour l'augmentation de la cadence des impulsions.

En ce qui concerne la source de pompage, le laser YAG permet d'utiliser un pompage continu ou impulsionnel.

En pompage impulsionnel, la source de pompage est une lampe à éclairs (ou lampe à flash). On utilisera par exemple une lampe à krypton. Le flash doit être préionisé au début de l'impulsion, par exemple par une tension élevée. La tension de fonctionnement de la lampe se situe dans la gamme de quelques centaines de volts, dépendant bien entendu de la longueur de décharge.

Le laser 5 illustré figure 2 comprend :
- une cavité laser 11 comprenant une lampe 12 et un barreau de YAG 13,
- de part et d'autre de la cavité 11, deux miroirs 14 et 15 positionnés dans l'axe du barreau 13,
- un circuit d'alimentation électrique 16 pour alimenter la lampe 12.

Typiquement, l'alimentation électrique de la lampe 12 est obtenue par la décharge brutale d'un condensateur préalablement chargé à une tension voulue. Le circuit d'alimentation 16 comprend donc essentiellement un circuit convertisseur de tension, un circuit de charge, et un circuit de commande. Ce circuit d'alimentation sera relié au circuit de commande 4, qui commandera la décharge, par le biais de moyens de communication 17.

L'entrée de la fibre optique 8 est située à proximité immédiate de la cavité 11, dans l'axe du barreau 13.

Le miroir 14 sera de type réfléchissant. Le miroir 15 sera de type semi-réfléchissant, et placé entre le barreau 13 et l'entrée de la fibre optique 8. Le faisceau laser 6 est obtenu en prélevant une partie du rayonnement laser présent dans la cavité 11. Le faisceau 6 est guidé, par le biais de la fibre optique 8, jusqu'au dispositif de collimation 9.

Ce dispositif de collimation 9 comprendra par exemple une lentille convergente pour focaliser le faisceau 6 si on souhaite marquer des circuits de surface inférieure au diamètre du faisceau 6.

On pourra prévoir de modifier le diamètre de marquage des circuits, en modifiant la position de la tranche par rapport au plan focal de la lentille :
- soit en prévoyant des moyens de déplacement de cette lentille convergente dans le dispositif de collimation 9,
- soit, en modifiant les positions relatives de la plate-forme 2 et du dispositif de collimation 9, ce qui est plus complexe du point de vue commande. En effet, il faudra alors tenir compte de ces positions relatives dans la commande du déplacement horizontal de la plate-forme 2, pour être certain que les circuits marqués correspondent à ceux jugés défectueux lors de l'étape de test. On pourra par exemple modifier la position de la plate-forme 2 en la déplaçant verticalement par translation, le dispositif de collimation 9 restant fixe. On pourra également modifier la position du dispositif de collimation 9 en le déplaçant verticalement le long de la potence 3, la plate-forme restant positionnée de manière fixe dans le plan vertical. On pourra aussi prévoir de modifier à la fois les positions de la plate-forme 2 et du dispositif de collimation 9.

De préférence, on utilisera la translation verticale de la plate-forme 2, afin de minimiser les réglages mécaniques de la position du dispositif de collimation, qui demandent une grande précision. On ne détaillera pas ici la structure détaillée des moyens de translation verticale et horizontale de la plate-forme. De tels moyens sont utilisés dans les appareils d'encrage traditionnels et donc connus de l'homme du métier.

Afin de vérifier que les diamètres de marquage ont la valeur souhaitée et que le marquage est centré par rapport aux circuits intégrés, l'appareil 1 comprendra classiquement un microscope 18 positionné au dessus de la plate-forme 2.

Dans l'exemple de réalisation décrit, on a positionné le dispositif de collimation légèrement de biais. On formera donc des marques en forme de patatoïdes. On pourra très bien intégrer le dispositif de collimation et le microscope dans une même structure si on souhaite pratiquer des marques circulaires, le faisceau laser dérivé étant alors dirigé verticalement.

En pompage impulsionnel, compte tenu des faibles dimensions usuelles des barreaux de YAG, l'énergie par impulsion est de l'ordre de quelques centaines de millijoules en fonctionnement déclenché.

La cadence des lasers impulsionnels pompés par flash est limitée par le temps de désionisation de la source de pompage. Mais, puisque le YAG peut être pompé en continu, on pourra éventuellement le munir d'un dispositif de déclenchement à prisme tournant ou électro-optique, et obtenir ainsi un fonctionnement impulsionnel déclenché à grande cadence. L'énergie ou la puissance de crête par impulsion seront toutefois notablement plus faibles que dans le cas du pompage impulsionnel, de puissance plus élevée.

En ce qui concerne les caractéristiques fonctionnelles on pourra prendre par exemple :
- un barreau 13 cylindrique de 4 millimètres de diamètre et de quelques centimètres de long,
- une lampe 12 à krypton.

On obtiendra ainsi un faisceau laser 6 ayant une longueur d'onde de 1060 nanomètres et 4 millimètres de diamètre.

Pour mettre en oeuvre le procédé selon l'invention, on procédera de la manière suivante :
- positionnement automatique d'une tranche de silicium sur la plate-forme 2 après le test de ces circuits par un appareil adapté,
- mise en oeuvre du marquage, en amenant successivement, par déplacement de la plate-forme 2, les circuits précédemment jugés défectueux dans l'axe du dispositif de collimation 9, et en déclenchant, pour chaque circuit jugé défectueux, l'exposition au faisceau laser 7 afin de faire fondre au moins une partie d'une ou plusieurs couches superficielles.

Si on souhaite que le marquage soit fonctionnellement destructif, on fait fondre les couches superficielles des circuits jugés défectueux sur une profondeur supérieure à l'épaisseur de la ou des couches de passivation, si elle existent.

Comme cela se pratique déjà de manière classique, les appareils de test fournissent un fichier informatique comprenant les coordonnées des circuits jugés défectueux, dans un système de repérage plan défini. Concernant le repérage des circuits, il se fera classiquement selon un point de référence et des axes perpendiculaires. On notera que l'on pourra déterminer physiquement une origine de référence en procédant au marquage laser d'un des circuits de la tranche avant l'étape de test.

On ne développera pas plus avant la coopération entre les appareils de test et de marquage, celle-ci étant analogue à ce qui se pratique déjà si on utilise un marquage différé à l'encre. Seul le dispositif de marquage va différer.

Le temps d'exposition de la surface d'un circuit au faisceau laser pour effectuer le marquage est de l'ordre de quelques millisecondes. Bien sûr, il dépendra de la puissance mise en oeuvre et du nombre de couches superficielles que l'on veut faire fondre. Plus l'énergie du faisceau sera importante, plus court sera la durée d'exposition pour un marquage équivalent.

La puissance, ou énergie, du laser dépendra de la technologie de fabrication des circuits, et plus particulièrement de la nature et de l'épaisseur de la couche de passivation.

Considérons par exemple les hypothèses suivantes :
- couche de passivation en oxyde de nitrure,
- épaisseur de la couche de passivation de 1 à 2 microns,
- diamètre de marquage de 500 microns (tâche de 0.785 millimètres carrés),
- fusion sur une profondeur égale à l'épaisseur de la couche de passivation (marquage non destructif),
- durée d'exposition au faisceau laser dérivé 7 de 3 millisecondes.

Une énergie de 360 millijoules par millimètre carré permettra d'obtenir ce résultat.

Si on considère que :
- le miroir 15 a un coefficient de transmission de 20 %,
- l'affaiblissement dans la fibre optique est de 0.7 dB (d'un point de vue énergétique, le faisceau laser 7 correspond à une fraction du faisceau laser 6, du fait des pertes entre l'entrée de la fibre optique 8 et la sortie du dispositif de collimation 9),
alors on choisira :
- un faisceau laser dérivé 7 ayant une énergie d'approximativement 280 millijoules,
- un faisceau laser 6 ayant une énergie d'approximativement 330 millijoules,
- un faisceau en sortie de la cavité résonante 11 ayant une énergie d'approximativement 1.6 joules.

Selon ces hypothèses, l'énergie au niveau de la surface des circuits intégrés sera de 1 joule par millimètre carré si le diamètre de marquage est de 300 microns, et de 280 millijoules par millimètre carré si le diamètre de marquage est de 1000 µm (microns).

La puissance nominale du laser sera fixée par la nature des couches superficielles et par la profondeur maximale de fusion envisagée.

Dans l'exemple décrit ci-dessus, une énergie de 280 millijoules par millimètre carré devra être suffisante pour entraîner une fusion de la couche de passivation.

Si le diamètre de marquage est plus faible, on pourra diminuer le temps d'exposition au faisceau 7 pour avoir une profondeur de fusion identique. On pourra également, dans ce même cas de figure, garder un temps d'exposition identique et changer la lentille 15 pour diminuer le coefficient de transmission de cette lentille.

Selon la nature des couches superficielles des circuits, pour des diamètres de marquage variant de 300 à 1000 µm (microns), et en considérant des temps d'exposition de l'ordre de grandeur de la milliseconde, on exposera les surfaces des circuits à un rayonnement tel que les énergies au niveau des surfaces circuits soit de l'ordre de 200 à 1200 millijoules par millimètre carré, voire plus.

Bien entendu, pour apprécier le temps total de marquage d'un circuit, on doit tenir compte du temps de recharge du laser entre deux expositions successives. Globalement, en suivant les hypothèses ci-dessus, le marquage d'un circuit durera une centaine de millisecondes.

Dans un dispositif d'encrage traditionnel, le temps nécessaire pour réaliser une tache d'encre est communément de l'ordre de 300 millisecondes, ce qui représente environ 1 % du temps nécessaire à l'ensemble des opérations de test et de marquage. La tendance étant à différencier les appareils de tests et de marquage, dans la mesure où la surface des circuits diminue, l'emploi d'un laser permettra de diminuer par trois le nombre d'appareils de marquage pour rapport au nombre d'appareils de tests, pour un rendement identique.

Or, le prix d'un appareil de marquage est très élevé, de l'ordre de quelques dizaines de kilofrancs. Le marquage au laser procure donc indéniablement une économie, en réduisant le nombre d'appareils nécessaires pour marquer un nombre donné de tranches de silicium.

Dans une machine d'encrage, pour éviter une dégradation de la qualité de l'encre déposée, on change les cartouches alors qu'il reste en moyenne 20 % de l'encre dans la cartouche.

Pour les hypothèses suivantes :
- 17 000 marquages/jour de circuits d'une surface de 1 mm²,
- marquage et test réalisés par 5 appareils d'encrage Xandex AS utilisent des cartouches Xandex 6997, et
- remplacement en moyenne des cartouches toutes les semaines et coût d'une cartouche égal à 120 francs,
le coût du matériau de marquage (encre) est approximativement de 7700 francs pour trois mois.

La lampe laser, pour produire un marquage équivalent, sera changée tous les trois mois et ne coûtera que 1200 francs.

On diminue ainsi le coût du matériau utilisé pour le marquage d'un facteur 7.

Par ailleurs, la marquage au laser procure des avantages quant à la durée globale des opérations de marquage, c'est à dire en terme de productivité.

En effet :
- on supprime une étape nécessaire de polymérisation, dans un four, de l'encre déposée,
- le remplacement d'une cartouche d'encre nécessite un certain nombre de réglages mécaniques dus au fait que les propriétés physiques de l'encre (viscosité, consistance) peuvent varier d'une cartouche à l'autre.

L'invention procure donc un gain de productivité, un gain économique, et une précision accrue.

Bien qu'on ait décrit l'invention en référence à un exemple de réalisation préféré, on comprendra que cet exemple n'est pas limitatif et que diverses modifications peuvent lui être apportées sans sortir du cadre de l'invention.

## Revendications

1. Procédé de marquage physique sur tranche de silicium, de circuits intégrés jugés défectueux lors d'une étape de test, de façon à modifier l'aspect visuel de la surface de ces circuits par exposition de leur surface à un rayonnement laser, caractérisé en ce que, l'ensemble des circuits intégrés de la tranche étant recouverts d'au moins une couche de passivation, on réalise le marquage desdits circuits jugés défectueux de manière à faire fondre les couches superficielles des circuits jugés défectueux sur une profondeur supérieure à l'épaisseur de leur couche de passivation pour les rendre inopérants.

2. Procédé selon la revendication 1, caractérisé en ce que l'énergie du rayonnement laser au niveau des surfaces des circuits est de l'ordre de 200 à 1200 millijoules par millimètre carré.

3. Procédé selon la revendication 1 ou 2, caractérisé en ce qu'on focalise le rayonnement laser de telle manière que le diamètre de marquage soit variable.

4. Procédé selon la revendication 3, caractérisé en ce que le diamètre de marquage est compris entre 300 et 1000 micromètres.

## Patentansprüche

1. Verfahren zur äußerlichen Kennzeichnung integrierter Schaltungen auf Siliziumscheiben, die bei einem Testlauf als defekt befunden wurden, zur Veränderung des Aussehens der Oberfläche dieser Schaltungen, indem ihre Oberfläche einer Laserstrahlung ausgesetzt wird, dadurch gekennzeichnet, daß man alle integrierten Schaltungen der Scheibe mit mindestens einer Passivierungsschicht versieht, man die als defekt befundenen Schaltungen kennzeichnet, indem man die Oberflächenschichten der als defekt befundenen Schaltungen auf einer Tiefe zum Schmelzen bringt, die größer ist als die Stärke ihrer Passivierungsschicht, um sie unbenutzbar zu machen.

2. Verfahren nach Anspruch 1, dadurch gekennzeichnet, daß die Laserstrahlungsenergie in Höhe der Oberflächen der Schaltungen im Bereich von 200 bis 1200 Millijoule pro Quadratmillimeter liegt.

3. Verfahren nach Anspruch 1 oder 2, dadurch gekennzeichnet, daß man die Laserstrahlung so fokussiert, daß der Kennzeichnungsdurchmesser variabel ist.

4. Verfahren nach Anspruch 3, dadurch gekennzeichnet, daß der Kennzeichnungsdurchmesser 300 bis 1000 Mikrometer beträgt.

## Claims

1. A method for physically marking, on a silicon wafer, integrated circuits which are judged to be defective during a test stage, so as to modify the visual appearance of the surface of these circuits by exposing their surface to laser irradiation,
**characterised in that**, as all the integrated circuits of the wafer are covered with at least one passivation layer, the marking of the said circuits judged to be defected is performed so as to fuse the superficial layers of the circuits judged to be defective to a depth greater than the thickness of their passivation layer in order to render them inoperative.

2. A method according to Claim 1,
**characterised in that** the energy of the laser irradiation at the level of the surfaces of the circuits is in the order of 200 to 1200 millijoules per square millimetre.

3. A method according to Claim 1 or 2,
**characterised in that** the laser irradiation is focussed in such a manner that the marking diameter is variable.

4. A method according to Claim 3,
**characterised in that** the marking diameter is between 300 and 1,000 micrometres.
